# NEUE EUROPÄISCHE PATENTSCHRIFT

(11) **EP 1 614 990 B2**
(45) Veröffentlichungstag und Bekanntmachung des Hinweises auf die Entscheidung über den Einspruch: **17.06.2020**
(45) Hinweis auf die Patenterteilung: 15.07.2009
(21) Anmeldenummer: 05010374.6
(22) Anmeldetag: 12.05.2005
(51) Int. Cl.: H03M 1/10, G01D 5/244, G01D 18/00

(54) **Positionsmesseinrichtung und Verfahren zur Positionsmessung**
Position sensor and method therefore
Capteur de position et méthode pour mésurer la position

(30) Priorität: 09.07.2004 DE 102004033266
(43) Veröffentlichungstag der Anmeldung: 11.01.2006
(73) Patentinhaber: Dr. Johannes Heidenhain GmbH, 83292 Traunreut (DE)
(72) Erfinder: Strasser, Erich, 83308 Trostberg (DE); Mayer, Elmar, Dr., 83365 Nussdorf (DE)
(74) Vertreter: Maikowski & Ninnemann Patentanwälte Partnerschaft mbB

(56) Entgegenhaltungen:
- EP-A- 0 707 198
- EP-A1- 0 707 198
- US-A- 3 143 666
- US-A- 3 996 612
- US-A- 5 095 447
- US-A- 6 163 286
- US-B1- 6 334 181

## Beschreibung

Die Erfindung betrifft eine Positionsmesseinrichtung mit integriertem Funktionstest, sowie ein Verfahren zur Positionsmessung in einer Positionsmesseinrichtung mit integriertem Funktionstest nach Anspruch 1, bzw. 8. Eine solche Positionsmesseinrichtung erlaubt es, bei jeder Positionsdatenanforderung zu überprüfen, ob die Übernahme der Positionsdaten in die internen Speichereinheiten der Positionsmesseinrichtung funktioniert.

Ein weit verbreitetes Einsatzgebiet für Positionsmesseinrichtungen, insbesondere Winkelmessgeräte, sind numerisch gesteuerte Werkzeugmaschinen. Sie werden dafür verwendet, Lageistwerte zu ermitteln, die die numerische Steuerung benötigt, um die Regelkreise zu steuern, mit denen der Vorschub des Werkzeugs oder des Werkstückes kontrolliert wird. Zu diesem Zweck werden sie meist direkt oder indirekt mit der Welle eines Motors gekoppelt.

Es ist offensichtlich, dass Fehlfunktionen in der Positionsdatenerfassung große Probleme hervorrufen können. Eine Fehlerursache kann sein, dass die Kopplung zwischen Motorwelle und Positionsmessgerät verloren geht, was dazu führt, dass das Positionsmessgerät immer den gleichen Positionswert liefert. Auf diese Weise kann es nicht nur passieren, dass das gerade bearbeitete Werkstück unbrauchbar wird, weil zuviel Material abgetragen wird, sondern auch, dass die Werkzeugmaschine einen Schaden davonträgt, weil z.B. ein Werkzeug mit einer schnell drehenden Spindel in Berührung kommt. Noch schlimmer als der finanzielle Schaden, der dabei entsteht, ist die Verletzungsgefahr für das Bedienpersonal.

Eine derartige Fehlfunktion kann verschiedene Ursachen haben. Eine davon ist ein Bruch der mechanischen Verbindung zwischen Positionsmessgerät und Motorwelle, die das Winkelmessgerät mit der Motorspindel verbindet. Durch einen derartigen mechanischen Wellenbruch kommt es zu einem Stillstand der Welle des Positionsmessgeräts und der Positionsmesswert ändert sich nicht mehr, obwohl sich die Motorwelle dreht.

Die weitere Ursache ist ein Ausfall in der elektronischen Auswertung der Positionsdaten im Positionsmessgerät, insbesondere eine Störung bei der Übernahme der Positionsdaten in einen Zwischenspeicher. Liegt beispielsweise ein Leitungsbruch der Steuerleitung vor, die das Einspeichern der Positionsdaten in den Zwischenspeicher steuert, ändern sich die im Zwischenspeicher abgelegten Positionsdaten nicht mehr und als Folge davon wird immer der gleiche Positionswert ausgegeben. Ein derartiger Defekt wird auch als elektronischer Wellenbruch bezeichnet.

Sowohl ein mechanischer, als auch ein elektronischer Wellenbruch kann in der numerischen Steuerung während des Positioniervorgangs schnell und zuverlässig erkannt werden. Während des Stillstandes einer Welle, also wenn eine Achse an einer bestimmten Position gehalten werden soll, ist das nicht möglich. Grund dafür ist, dass die numerische Steuerung nicht unterscheiden kann, ob sich der Antrieb einer Achse tatsächlich nicht bewegt, oder ob sich nur der Positionswert nicht mehr ändert.

Während ein mechanischer Wellenbruch im Stillstand, also ohne dass eine Kraft auf die Welle des Winkelmessgeräts einwirkt, als unwahrscheinlich anzunehmen ist, kann ein elektronischer Wellenbruch unabhängig von der Vorschubbewegung auftreten. Zur Erkennung eines elektronischen Wellenbruchs werden in den Positionsmessgeräten, wie sie im Stand der Technik weit verbreitet sind, häufig zusätzlich zu den digital kodierten Positionswerten noch analoge Spursignale übertragen. Dabei handelt es sich um sin/cos-Signale, die nach dem bekannten Prinzip der inkrementellen Positionsmessung erzeugt werden. Bei der Auswertung der Positionsdaten in der numerischen Steuerung wird überprüft, ob sich sowohl die digitalen, als auch die analogen Positionswerte ändern. Ist das nicht der Fall, z.B. wenn die digital kodierten Positionswerte konstant bleiben, während sich die analogen Signale weiter verändern, erkennt die Steuerung den Defekt und kann entsprechende Maßnahmen auslösen.

Nachteil dieses Verfahrens ist der erhöhte Aufwand für die zusätzliche Erzeugung, Übertragung und Auswertung der analogen Signale. Dieser Nachteil wird durch die Bestrebungen, zwischen Positionsmessgeräten und der numerischen Steuerung nur noch rein digitale Schnittstellen zu verwenden, noch verstärkt.

Es ist daher Aufgabe der Erfindung, ein Positionsmessgerät mit integriertem Funktionstest anzugeben, mit dem ein elektronischer Wellenbruch ohne analoge Spursignale auch im Stillstand erkannt werden kann.

Diese Aufgabe wird gelöst durch eine Positionsmesseinrichtung mit integriertem Funktionstest nach Anspruch 1. Vorteilhafte Details ergeben sich aus den von Anspruch 1 abhängigen Ansprüchen.

Weiterhin ist es Aufgabe der Erfindung, ein Verfahren zur Positionsmessung anzugeben, mit dem ein elektronischer Wellenbruch ohne analoge Spursignale auch im Stillstand erkannt werden kann.

Diese Aufgabe wird gelöst durch ein Verfahren nach Anspruch 8. Vorteilhafte Details des Verfahrens ergeben sich aus den von Anspruch 8 abhängigen Ansprüchen.

Es wird nun eine Positionsmesseinrichtung mit integriertem Funktionstest vorgeschlagen, die aus einer Positionserfassungseinheit, einer Verarbeitungseinheit und einem Kontrollwortgenerator besteht. Bei einer Positionsdatenanforderung wird zuerst in der Positionserfassungseinheit ein Positionsdatenwort erzeugt und an die Verarbeitungseinheit ausgegeben. Dort wird das Positionsdatenwort zu einem Positionswert verarbeitet. Anschließend wird nach Vorgabe des Kontrollwortgenerators in der Positionserfassungseinheit ein Kontrolldatenwort erzeugt und an die Verarbeitungseinheit ausgegeben. Die Verarbeitungseinheit verarbeitet das Kontrolldatenwort zu einem Kontrollwert, der einen definierten mathematischen Zusammenhang zum Positionswert aufweist.

Weitere Vorteile sowie Einzelheiten der erfindungsgemäßen Positionsmesseinrichtung mit integriertem Funktionstest, bzw. des erfindungsgemäßen Verfahrens zur Positionsmessung ergeben sich aus der nachfolgenden Beschreibung von Ausführungsbeispielen anhand der beiliegenden Figuren.

Dabei zeigt
- Figur 1: ein Blockdiagramm einer ersten Ausführungsform einer erfindungsgemäßen Positionsmesseinrichtung,
- Figur 2: ein Ablaufdiagramm eines Verfahrens zur Positionsdatenerfassung mit einer Positionsmesseinrichtung nach Figur 1,
- Figur 3: ein Blockdiagramm einer zweiten Ausführungsform einer erfindungsgemäßen Positionsmesseinrichtung und
- Figur 4: ein Ablaufdiagramm eines Verfahrens zur Positionsdatenerfassung mit einer Positionsmesseinrichtung nach Figur 3.

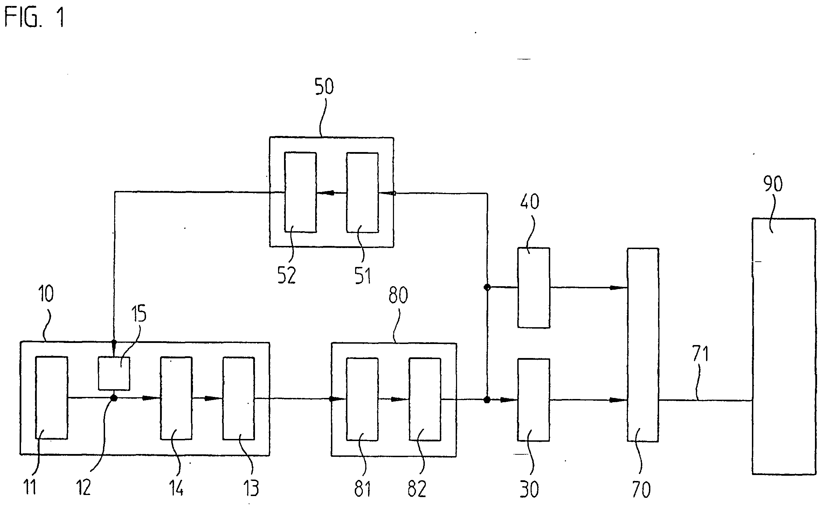

Figur 1 zeigt ein Blockdiagramm einer ersten Ausführungsform einer erfindungsgemäßen Positionsmesseinrichtung. Sie besteht aus einer Positionserfassungseinheit 10, einem Ergebnisspeicher 30, einem Kontrollwortspeicher 40, einem Kontrollwortgenerator 50, einer Schnittstelleneinheit 70 und einer Verarbeitungseinheit 80.

In der Positionserfassungseinheit 10 wird ein Positionsdatenwort mit wenigstens einem Bit Breite gebildet. Das Positionsdatenwort kann dabei beliebig kodiert sein und eine beliebig hohe Redundanz aufweisen. Außerdem kann es Zusatzinformationen enthalten, die beispielsweise bei der späteren Auswertung erlauben, für den Positionswert gültige Bits zu identifizieren.

Die Positionserfassungseinheit 10 der Positionsmesseinrichtung in Figur 1 besteht aus einem Messwertaufnehmer 11, wenigstens einem Stromknotenpunkt 12, einem Zwischenspeicher 13, einer Signalaufbereitungseinheit 14 und einem Spannungs-Stromwandler 15.

Die Erzeugung des Positionsdatenwortes im Messwertaufnehmer 11 kann auf bekannten, insbesondere optischen Abtastprinzipien beruhen. Dabei wird Licht, das von einer Lichtquelle auf eine Anzahl von Photodetektoren abgestrahlt wird, über eine Messteilung, die beweglich im Strahlengang des Lichts angeordnet ist, moduliert, wenn die Messteilung relativ zur Lichtquelle und den Photodetektoren bewegt wird. Je nachdem, ob es sich um ein rotatorisches oder lineares Positionsmessgerät handelt, ist die Messteilung auf einer kreisrunden Teilungsscheibe oder einem Maßstab aufgebracht. Die Messteilung kann aus einer oder mehreren Spuren mit Bereichen mit unterschiedlichen optischen Eigenschaften wie z.B. transparent/opak oder reflektierend/nicht reflektierend, bestehen. Bei den Ausgangssignalen des Messwertaufnehmers 11 handelt es sich um analoge Stromsignale, deren Ausgangsstrom sich je nach Beleuchtungsstärke ändert. Jedes Bit des so erzeugten Positionsdatenwortes wird somit durch ein analoges Stromsignal repräsentiert.

Der Positionserfassungseinheit 10 kann vom Kontrollwortgenerator 50 ein Kontrolldatenwort vorgegeben werden. Die einzelnen Bits des Kontrolldatenwortes werden in einem Spannungs-Stromwandler 15 ebenfalls in Stromsignale umgewandelt, die mit den dazugehörigen Bits des Positionsdatenwortes über Stromknotenpunkte 12 verbunden sind. Die Amplitude der Stromsignale ist dabei so eingestellt, dass die jeweiligen Summenstromsignale an den Stromknotenpunkten 12 von den Stromsignalen des Kontrolldatenwortes dominiert werden. In anderen Worten wird das Positionsdatenwort am Ausgang des Messwertaufnehmers 11 vom Kontrolldatenwort überschrieben. Die Stromknotenpunkte 12 und der Spannungs-Stromwandler 15 stellen somit Mittel 12, 15 dar, durch die einstellbar ist, ob die Positionserfassungseinheit 10 das Positionsdatenwort oder das Kontrolldatenwort ausgibt.

Die Summenstromsignale der Stromknotenpunkte 12 werden der Signalaufbereitungseinheit 14 zugeführt, in der sie in digitale Spannungssignale umgewandelt werden, die ein Datenwort bilden, das dem Zwischenspeicher 13 zugeführt wird und dort eingespeichert werden kann. Beim Datenwort, das sich im Zwischenspeicher 13 befindet, kann es sich somit um das Positionsdatenwort oder um das Kontrolldatenwort handeln.

Die hier beschriebene Ausführungsform einer erfindungsgemäßen Positionsmesseinrichtung bezieht sich auf einen Messwertaufnehmer 11, dessen Ausgangssignale aus Stromsignalen bestehen. Für einen Fachmann ist es jedoch offensichtlich, dass das Funktionsprinzip, das Positionsdatenwort mit dem Kontrolldatenwort zu überschreiben, mit geringfügigen Änderungen auch dann angewendet werden kann, wenn es sich bei den Ausgangssignalen des Messwertaufnehmers 11 um Spannungssignale handelt.

Der Inhalt des Zwischenspeichers 13 bildet den Ausgang der Positionserfassungseinheit 10 und ist mit der Verarbeitungseinheit 80 verbunden. Unabhängig davon, ob es sich bei dem Datenwort, das von der Positionserfassungseinheit 10 ausgegeben wird, um ein Positionsdatenwort oder ein Kontrolldatenwort handelt, verarbeitet die Verarbeitungseinheit 80 das Datenwort immer gleich. Wenn es sich um das Positionsdatenwort handelt, entspricht das Ergebnis am Ausgang der Verarbeitungseinheit 80 dem Positionswert. Handelt es sich dagegen um das Kontrolldatenwort, entspricht das Ergebnis dem Kontrollwert. Der Ausgang der Verarbeitungseinheit 80 ist dem Ergebnisspeicher 30, dem Kontrollwertspeicher 40 und dem Kontrollwortgenerator 50 zugeführt.

Die Verarbeitungseinheit 80 enthält zum Verarbeiten des Datenwortes eine Auswerteeinheit 81 und eine Vorwärtstabelle 82. Die Auswerteeinheit 81 dient dazu, die Gültigkeit des Positionsdatenwortes zu prüfen und aus den im Positionsdatenwort enthaltenen Informationen einen kodierten Positionswert zu extrahieren. Dieser wird über die Vorwärtstabelle 82 dekodiert und über den Ausgang der Verarbeitungseinheit 80 ausgegeben.

Der Kontrollwortgenerator 50 enthält einen Offsetaddierer 51, um zum dekodierten Positionswert am Ausgang der Verarbeitungseinheit 80 einen Offsetwert K zu addieren. Das daraus resultierende Datenwort wird über eine Rückwärtstabelle 52 kodiert und auf eine Form gebracht, die der Form der Positionsinformation im Positionsdatenwort entspricht. Gibt der Kontrollwortgenerator 50 das so entstandene Kontrollwort an die Positionserfassungseinheit 10 aus, so wird in der Positionserfassungseinheit 10 das aktuelle Positionsdatenwort am Ausgang des Messwertaufnehmers überschrieben und stattdessen das Kontrolldatenwort ausgegeben.

Der im Ergebnisspeicher 30 abgespeicherte Positionswert und der im Kontrollwertspeicher 40 abgespeicherte Kontrollwert sind der Schnittstelleneinheit 70 zugeführt und können über die Datenübertragungsleitung 71 zu einer Folgeelektronik 90 übertragen werden.

In der Folgeelektronik kann nun durch Bildung der Differenz zwischen dem Kontrollwert und dem Positionswert und durch Vergleich des Resultats mit dem bekannten Offsetwert K feststellt werden, ob Kontrollwert und Positionswert fehlerfrei erzeugt und übertragen wurden.

Alternativ dazu kann die Auswertung durch Differenzbildung und Vergleich selbstverständlich auch bereits in der Positionsmesseinrichtung vorgenommen werden. In diesem Fall wäre es ausreichend, nur den Positionswert und das Ergebnis der Auswertung, beispielsweise durch ein Statusbit, zur Folgeelektronik 90 zu übertragen. Die zu übertragende Datenmenge könnte so reduziert werden. Die oben beschriebene Variante hat aber den Vorteil, dass zusätzlich die fehlerfreie Übertragung über die Schnittstelleneinheit 70 und die Datenübertragungsleitung 71 überprüft wird.

Bei der Schnittstelleneinheit 70 handelt es sich vorzugsweise um eine serielle Schnittstelle.

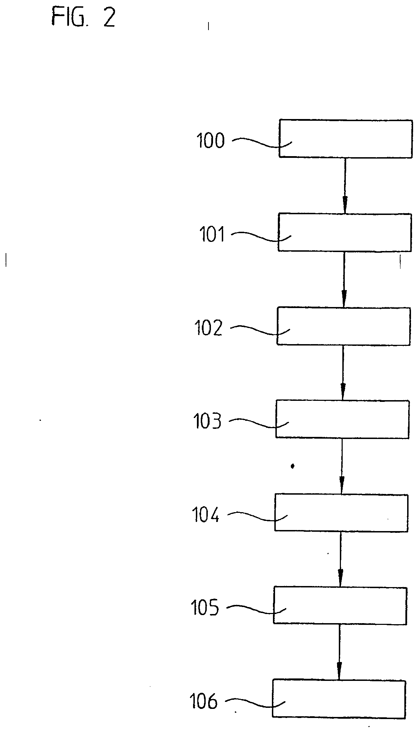

Das Ablaufdiagramm in Figur 2 verdeutlicht das Verfahren zur Positionsdatenerfassung in einer Positionsmesseinrichtung nach Figur 1.

In einem Schritt 100 wird, beispielsweise durch eine Signalflanke auf der Datenübertragungsleitung 71, eine Positionsmessung initiiert und eine Positionsdatenerfassung gestartet.

Im Schritt 101 wird von der Positionserfassungseinheit 10 das aktuell am Ausgang des Messwertaufnehmers 11 anstehende Positionsdatenwort über die Stromknotenpunkte 12 an die Signalaufbereitungseinheit 14 weitergeleitet, in der die analogen Stromsignale in digitale Spannungssignale umgewandelt werden. Diese bilden ein Datenwort, das dem Zwischenspeicher 13 zugeführt und dort eingespeichert wird. Der Inhalt des Zwischenspeichers 13 wird am Ausgang der Positionserfassungseinheit 10 ausgegeben.

In der Verarbeitungseinheit 80 wird aus dem Inhalt des Zwischenspeichers 13 im Schritt 102 zuerst in der Auswerteeinheit 81 ein kodierter Positionswert gebildet und dieser anschließend mit Hilfe der Vorwärtstabelle 82 dekodiert. Der so aus dem Inhalt des Zwischenspeichers 13 abgeleitete Positionswert wird in den Ergebnisspeicher 30 eingespeichert und dem Kontrollwortgenerator 50 zugeführt. Über den Ausgang des Ergebnisspeichers 30 steht der Positionswert auch der Schnittstelleneinheit 70 zur Verfügung.

Im Schritt 103 wird im Offsetaddierer 51 des Kontrollwortgenerators 50 zum aus dem Inhalt des Zwischenspeichers 13 abgeleiteten Positionswert der Offsetwert K addiert und das daraus resultierende Datenwort über die Rückwärtstabelle 52 kodiert. Das so entstandene Kontrolldatenwort wird an die Positionserfassungseinheit 10 ausgegeben.
In der Positionserfassungseinheit 10 werden in Schritt 104 die Bits dieses Kontrolldatenwortes im Spannungs-Stromwandler 15 in Stromsignale umgewandelt, die an den Stromknotenpunkten 12 das aktuelle Positionsdatenwort überschreiben. Die Summenstromsignale der Stromknotenpunkte 12 werden in der Signalaufbereitungseinheit 14 wieder in Spannungssignale umgewandelt und in den Zwischenspeicher 13 eingespeichert. Der Inhalt des Zwischenspeichers 13 entspricht nun dem Kontrolldatenwort und wird am Ausgang der Positionserfassungseinheit 10 ausgegeben.

In Schritt 105 wird in der Verarbeitungseinheit 80 aus dem Kontrolldatenwort zuerst in der Auswerteeinheit 81 ein kodierter Kontrollwert gebildet und dieser anschließend mit Hilfe der Vorwärtstabelle 82 dekodiert. Der so aus dem Kontrolldatenwort abgeleitete Kontrollwert wird in den Kontrollwertspeicher 40 eingespeichert und über den Ausgang des Kontrollwertspeichers 40 an die Schnittstelleneinheit 70 ausgegeben.

In Schritt 106 werden der Positionswert und der Kontrollwert über die Schnittstelleneinheit 70 und die Datenübertragungsleitung 71 zur Folgeelektronik 90 übertragen. Dort können nun über den bekannten mathematischen Zusammenhang, den die beiden Werte zueinander aufweisen, Rückschlüsse auf die Funktion der Positionsmesseinrichtung gezogen werden. Das kann beispielsweise dadurch geschehen, dass die Differenz zwischen dem Positionswert und dem Kontrollwert gebildet und das Resultat mit dem erwarteten Offsetwert K verglichen wird. Insbesondere kann so die fehlerfreie Übernahme des Positionsdatenwortes bzw. des Kontrolldatenwortes in den Zwischenspeicher 13, sowie das Einspeichern des Positionswertes in den Ergebnisspeicher 30 und des Kontrollwertes in den Kontrollwertspeicher 40 überprüft werden. Da die Auswertung in der Folgeelektronik vorgenommen wird, wird automatisch auch die fehlerfreie Übertragung der Daten zur Folgeelektronik 90 geprüft.

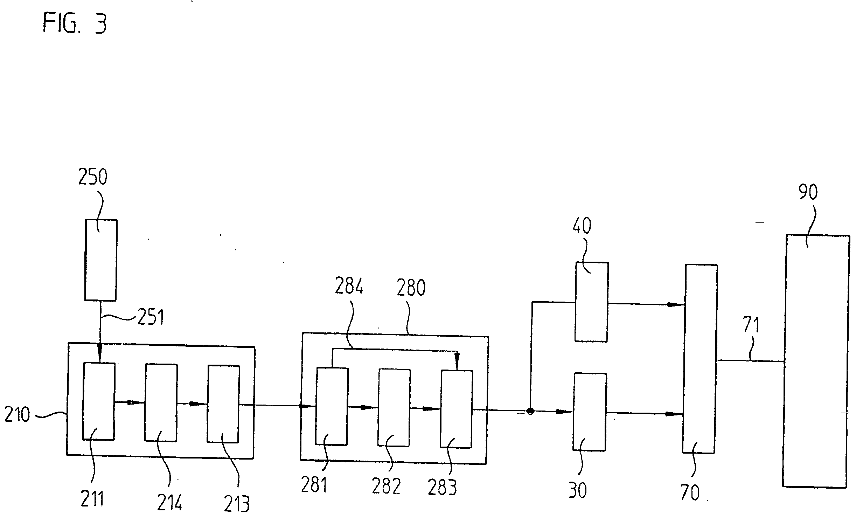

Figur 3 zeigt ein Blockdiagramm einer weiteren Ausführungsform einer erfindungsgemäßen Positionsmesseinrichtung. Sie besteht aus einer Positionserfassungseinheit 210, einem Ergebnisspeicher 30, einem Kontrollwertspeicher 40, einem Kontrollwortgenerator 250, einer Schnittstelleneinheit 70 und einer Verarbeitungseinheit 280. Komponenten die die gleiche Funktion wie in Figur 1 erfüllen, sind mit dem gleichen Bezugszeichen versehen und werden nicht mehr ausführlich beschrieben.

Die Positionserfassungseinheit 210 arbeitet nach dem oben beschriebenen optischen Abtastprinzip. Wie in Figur 1 wird im Messwertaufnehmer 211 ein Positionsdatenwort mit wenigstens einem Bit Breite erzeugt, das aus Stromsignalen besteht, die in einer Signalaufbereitungseinheit 214 zu Spannungssignalen umgewandelt werden und in einem Zwischenspeicher 213 speicherbar sind.

Dem Messwertaufnehmer 211 ist vom Kontrollwortgenerator 250 eine Schaltleitung 251 zugeführt, über die der Messwertaufnehmer 211 deaktiviert werden kann. Das kann beispielsweise dadurch geschehen, indem eine Lichtquelle, die sich entsprechend dem Abtastprinzip im Messwertaufnehmer 211 befindet, abgeschaltet wird. Eine weitere Möglichkeit ist, dass mit der Schaltleitung 251 im Messwertaufnehmer 211 enthaltene Photodetektoren deaktiviert werden. Je nach Funktionsweise des Messwertaufnehmers 211 sind ggf. andere Maßnahmen erforderlich, diesen zu deaktivieren.
Im deaktivierten Zustand wird vom Messwertaufnehmer 211 ein Kontrolldatenwort generiert, bei dem alle Bits einen logischen Low-Pegel aufweisen. Dieses Kontrolldatenwort ist eindeutig von einem Positionsdatenwort unterscheidbar, da es keinen gültigen Positionswert enthält. Die Schaltleitung 251 bildet somit ein Mittel 251, mit dem einstellbar ist, ob am Ausgang der Positionserfassungseinheit 210 ein Positionsdatenwort oder ein Kontrolldatenwort ausgegeben wird.

Die Verarbeitungseinheit 280 dient dazu, das Positionsdatenwort zu einem Positionswert und das Kontrolldatenwort zu einem Kontrollwert zu verarbeiten, wobei Positionswert und Kontrollwert einen definierten mathematischen Zusammenhang zueinander aufweisen. Sie beinhaltet eine Auswerteeinheit 281, eine Vorwärtstabelle 282, eine Kennzeichnungseinheit 283, sowie eine Meldeleitung 284.
In der Auswerteeinheit 281 wird geprüft, ob es sich bei dem Datenwort am Eingang der Verarbeitungseinheit 280 um ein gültiges Datenwort handelt, d.h. ob es einen kodierten Positionswert beinhaltet. Das Ergebnis der Prüfung wird der Kennzeichnungseinheit 283 über eine Meldeleitung 284 mitgeteilt.

Aus einem gültigen Datenwort wird in der Auswerteeinheit 281 ein kodierter Positionswert gebildet und zur Vorwärtstabelle 282 weitergeleitet, in der er zu einem Positionswert dekodiert wird. Dieser wird unverändert durch die Kennzeichnungseinheit 283 geleitet und am Ausgang der Verarbeitungseinheit 280 ausgegeben.

Wird der Kennzeichnungseinheit 283 über die Meldeleitung 284 signalisiert, dass es sich um ein ungültiges Datenwort handelt, addiert die Kennzeichnungseinheit 283 zum letzten ermittelten Positionswert, der ihr zu diesem Zeitpunkt noch zur Verfügung steht, einen Offsetwert K und gibt das Ergebnis als Kontrollwert am Ausgang der Verarbeitungseinheit 280 aus.

Mit der Auswerteeinheit 281, der Vorwärtstabelle 282, der Kennzeichnungseinheit 283 und der Meldeleitung 284 verfügt die Verarbeitungseinheit 280 somit über Mittel 281, 282, 283, 284, um das Positionsdatenwort zu einem Positionswert und das Kontrolldatenwort zu einem Kontrollwert zu verarbeiten.

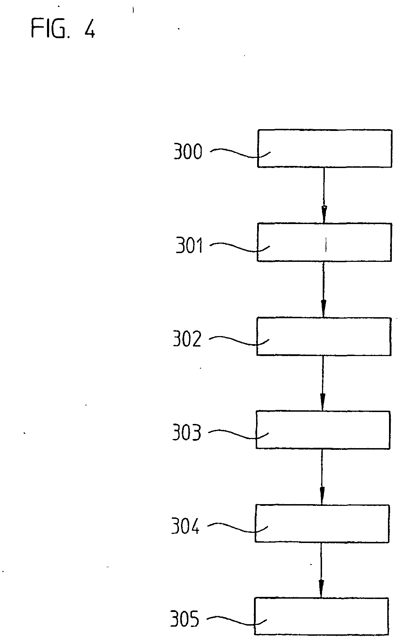

Das Ablaufdiagramm in Figur 4 verdeutlicht das Verfahren zur Positionsdatenerfassung in einer Positionsmesseinrichtung nach Figur 3.

Im Schritt 300 wird eine Positionsdatenerfassung gestartet.

In Schritt 301 wird das analoge Positionsdatenwort, das zu diesem Zeitpunkt am Ausgang des Messwertaufnehmers 211 in Form von wenigstens einem Stromsignal ausgegeben wird, in der Signalaufbereitungseinheit 214 in ein digitales Positionsdatenwort umgewandelt und in den Zwischenspeicher 213 eingespeichert. Der Inhalt des Zwischenspeichers 213 wird am Ausgang der Positionserfassungseinheit 210 ausgegeben.

In der Verarbeitungseinheit 280 wird in Schritt 302 das ankommende Positionsdatenwort zuerst in der Auswerteeinheit 281 auf Gültigkeit geprüft und das Ergebnis der Überprüfung über die Meldeleitung 284 der Kennzeichnungseinheit 283 mitgeteilt. Da es sich bei dem Positionsdatenwort um einen tatsächlich gemessenen Wert handelt, ist das Ergebnis der Prüfung positiv. Daher bildet die Auswerteeinheit 281 aus dem Positionsdatenwort einen kodierten Positionswert und leitet ihn an die Vorwärtstabelle 282 weiter, wo er zu einem Positionswert dekodiert wird. Da der Kennzeichnungseinheit 283 über die Meldeleitung 284 ein gültiger Positionswert signalisiert wird, wird dieser unverändert am Ausgang der Verarbeitungseinheit 280 ausgegeben und in den Ergebnisspeicher 30 eingespeichert.

In Schritt 303 deaktiviert der Kontrollwortgenerator 250 über die Schaltleitung 251 den Messwertaufnehmer 211. Unabhängig vom aktuellen Positionsdatenwort gibt der Messwertaufnehmer 211 nun ein analoges Kontrolldatenwort aus, bei dem alle Bits einen logischen Low-Pegel aufweisen. Dieses wird in der Signalaufbereitungseinheit 214 in ein digitales Kontrolldatenwort umgewandelt und in den Zwischenspeicher 213 eingespeichert.

In der Verarbeitungseinheit 280 wird das Kontrolldatenwort in Schritt 304 zuerst von der Auswerteeinheit 281 auf Gültigkeit geprüft. Die Auswerteeinheit 281 erkennt das Kontrolldatenwort als ungültig, da es keinen gültigen Positionswert enthält und teilt dieses Ergebnis der Kennzeichnungseinheit 283 über die Meldeleitung 284 mit. Daraufhin addiert die Kennzeichnungseinheit 283 zum letzten Positionswert, der in diesem Beispiel in Schritt 301 erzeugt wurde, einen Offsetwert K und gibt den so generierten Kontrollwert am Ausgang der Verarbeitungseinheit 280 aus. Der Kontrollwert weist so einen definierten mathematischen Zusammenhang zum Positionswert auf und wird in den Kontrollwertspeicher 40 eingespeichert.

In Schritt 305 werden die Inhalte von Ergebnisspeicher 30 und Kontrollwertspeicher 40 über die Schnittstelleneinheit 70 und der Datenübertragungsleitung 71 zu einer Folgeelektronik 90 übertragen. Wie oben bereits beschrieben, können dort über den bekannten mathematischen Zusammenhang, den die beiden Werte zueinander aufweisen, Rückschlüsse über die Funktion der Positionsmesseinrichtung, insbesondere über die fehlerfreie Übernahme der internen Daten in den Zwischenspeicher 213, den Ergebnisspeicher 30 und den Kontrollwertspeicher 40, gezogen werden.

Die beschriebenen Ausführungsformen einer Positionsmesseinrichtung mit integriertem Funktionstest sowie der Verfahren zur Positionsmessung lassen sich im Rahmen der Erfindung selbstverständlich abwandeln und an verschiedenste Anforderungen anpassen.

## Patentansprüche

1. Positionsmesseinrichtung mit integriertem Funktionstest, bestehend aus einer Positionserfassungseinheit (10; 210), einer Verarbeitungseinheit (80; 280) und einem Kontrollwortgenerator (50; 250), wobei
• in der Positionserfassungseinheit (10; 210) ein Positionsdatenwort, das einen aktuellen Positionswert enthält, und ein Kontrolldatenwort erzeugbar und an die Verarbeitungseinheit (10; 210) ausgebbar ist,
• die Positionserfassungseinheit (10; 210) mit der Verarbeitungseinheit (80; 280) verbunden ist, die Mittel (81, 82; 281, 282, 283, 284) enthält, um aus dem Positionsdatenwort einen Positionswert und aus dem Kontrolldatenwort einen Kontrollwert zu generieren, wobei der Kontrollwert und der Positionswert einen definierten mathematischen Zusammenhang zueinander aufweisen,
• der Kontrollwortgenerator (50; 250) ein Mittel (51, 52; 251) enthält, durch das einstellbar ist, ob von der Positionserfassungseinheit (10; 210) das Positionsdatenwort oder das Kontrolldatenwort ausgegeben wird.

2. Positionsmesseinrichtung nach Anspruch 1, wobei der Positionswert in einem Ergebnisspeicher (30) und der Kontrollwert in einem Kontrollwertspeicher (40) speicherbar sind.

3. Positionsmesseinrichtung nach Anspruch 2, wobei der Inhalt des Ergebnisspeichers (30) und der Inhalt des Kontrollwertspeichers (40) mittels einer Schnittstelleneinheit (70) über eine Datenübertragungsleitung (71) zu einer Folgeelektronik (90) übertragbar sind.

4. Positionsmesseinrichtung nach einem der vorhergehenden Ansprüche, wobei die Positionserfassungseinheit (10) Mittel (12, 15) zum Überschreiben des Positionsdatenwortes durch das Kontrolldatenwort enthält

5. Positionsmesseinrichtung nach Anspruch 4, wobei die Mittel (12, 15) zum Überschreiben des Positionsdatenwortes durch das Kontrolldatenwort aus einem Spannungs-Stromwandler (15) und wenigstens einem Stromknotenpunkt (12) bestehen.

6. Positionsmesseinrichtung nach einem der Ansprüche 1 bis 3, wobei ein Mittel (251) vorhanden ist, mit dem in der Positionserfassungseinheit (210) ein ungültiger Positionswert erzwingbar ist.

7. Positionsmesseinrichtung nach Anspruch 6, wobei das Mittel (251), mit dem in der Positionserfassungseinheit (210) ein ungültiger Positionswert erzwingbar ist, aus einer Schaltleitung (251) besteht, die einem Messwertaufnehmer (211) vom Kontrollwortgenerator (250) zugeführt ist und der Messwertaufnehmer (211) über die Schaltleitung (251) deaktivierbar ist.

8. Verfahren zur Positionsmessung in einer Positionsmesseinrichtung mit integriertem Funktionstest, die aus einer Positionserfassungseinheit (10; 210), einer Verarbeitungseinheit (80; 280) und einem Kontrollwortgenerator (50; 250) besteht, mit folgenden Schritten:
• Erzeugung eines Positionsdatenwortes in der Positionserfassungseinheit (10; 210) und Ausgabe des Positionsdatenwortes an die Verarbeitungseinheit (80; 280),
• Verarbeitung des Positionsdatenwortes zu einem Positionswert in der Verarbeitungseinheit (80; 280),
• Erzeugung eines Kontrolldatenwortes in der Positionserfassungseinheit (10; 210) anhand der Vorgabe des Kontrollwortgenerators (50; 250) und Ausgabe des Kontrolldatenwortes an die Verarbeitungseinheit (80; 280),
• Verarbeitung des Kontrolldatenwortes in der Verarbeitungseinheit (80; 280) zu einem Kontrollwert, der einen definierten mathematischen Zusammenhang zum Positionswert aufweist,
wobei durch ein Mittel des Kontrollwortgenerators (50; 250) eingestellt wird, ob von der Positionserfassungseinheit (10; 210) das Positionsdatenwort oder das Kontrolldatenwort ausgegeben wird.

9. Verfahren nach Anspruch 8, wobei der Positionswert in einem Ergebnisspeicher (30) und der Kontrollwert in einem Kontrollwertspeicher (40) abgespeichert werden.

10. Verfahren nach Anspruch 9, wobei sowohl der im Ergebnisspeicher (30) abgespeicherte Positionswert, als auch der im Kontrollwertspeicher (40) abgespeicherte Kontrollwert von einer Schnittstelleneinheit (70) über eine Signalübertragungsleitung (71) zu einer Folgeelektronik (90) übertragen werden.

11. Verfahren nach einem der Ansprüche 8 bis 10, wobei das Kontrolldatenwort in der Positionserfassungseinheit (10) das Positionsdatenwort überschreibt.

12. Verfahren nach einem der Ansprüche 8 bis 10, wobei das Kontrolldatenwort dadurch erzeugt wird, dass vom Kontrollwortgenerator (250) in der Positionserfassungseinheit (210) ein ungültiger Positionswert erzwungen wird.

13. Verfahren nach Anspruch 12, wobei der ungültige Positionswert dadurch erzwungen wird, dass ein Messwertaufnehmer (211) in der Positionserfassungseinheit (210) über eine Schaltleitung (251) deaktiviert wird.

14. Verfahren nach Anspruch 12 oder 13, wobei der Kontrollwert, den die Verarbeitungseinheit (280) generiert, wenn das Kontrolldatenwort keinen gültigen Positionswert enthält, aus dem zuvor ermittelten Positionswert besteht, zu dem ein Offsetwert (K) addiert wird.

## Claims

1. Position measuring device with an integrated functional test, comprising a position capture unit (10; 210), a processing unit (80; 280) and a control word generator (50; 250), wherein
• a position data word, which contains a current position value, and a control data word can be generated in the position capture unit (10; 210) and can be output to the processing unit (10; 210),
• the position capture unit (10; 210) is connected to the processing unit (80; 280) which contains means (81, 82; 281, 282, 283, 284) for generating a position value from the position data word and a control value from the control data word, wherein the control value and the position value have a defined mathematical relationship with respect to one another,
• the control word generator (50; 250) contains a means (51, 52; 251) which can be used to set whether the position data word or the control data word is output by the position capture unit (10; 210).

2. Position measuring device according to Claim 1, wherein the position value can be stored in a result memory (30) and the control value can be stored in a control value memory (40).

3. Position measuring device according to Claim 2, wherein the content of the result memory (30) and the content of the control value memory (40) can be transmitted, by means of an interface unit (70), to subsequent electronics (90) via a data transmission line (71).

4. Position measuring device according to one of the preceding claims, wherein the position capture unit (10) contains means (12, 15) for overwriting the position data word with the control data word.

5. Position measuring device according to Claim 4, wherein the means (12, 15) for overwriting the position data word with the control data word comprise a voltage/current transformer (15) and at least one current node (12).

6. Position measuring device according to one of Claims 1 to 3, wherein there is a means (251) which can be used to force an invalid position value in the position capture unit (210).

7. Position measuring device according to Claim 6, wherein the means (251) which can be used to force an invalid position value in the position capture unit (210) comprises a switching line (251) which is supplied to a measuring sensor (211) from the control word generator (250), and the measuring sensor (211) can be deactivated via the switching line (251).

8. Method for measuring a position in a position measuring device with an integrated functional test, which comprises a position capture unit (10; 210), a processing unit (80; 280) and a control word generator (50; 250), having the following steps of:
• generating a position data word in the position capture unit (10; 210) and outputting the position data word to the processing unit (80; 280),
• processing the position data word to a position value in the processing unit (80; 280),
• generating a control data word in the position capture unit (10; 210) on the basis of the specification of the control word generator (50; 250) and outputting the control data word to the processing unit (80; 280),
• processing the control data word in the processing unit (80; 280) to a control value which has a defined mathematical relationship with respect to the position value,
wherein a means of the control word generator (50; 250) is used to set whether the position data word or the control data word is output by the position capture unit (10; 210).

9. Method according to Claim 8, wherein the position value is stored in a result memory (30) and the control value is stored in a control value memory (40).

10. Method according to Claim 9, wherein both the position value stored in the result memory (30) and the control value stored in the control value memory (40) are transmitted, by an interface unit (70), to subsequent electronics (90) via a signal transmission line (71).

11. Method according to one of Claims 8 to 10, wherein the control data word overwrites the position data word in the position capture unit (10).

12. Method according to one of Claims 8 to 10, wherein the control data word is generated by the control word generator (250) forcing an invalid position value in the position capture unit (210).

13. Method according to Claim 12, wherein the invalid position value is forced by deactivating a measuring sensor (211) in the position capture unit (210) via a switching line (251).

14. Method according to Claim 12 or 13, wherein the control value generated by the processing unit (280) when the control data word does not contain a valid position value comprises the previously determined position value, to which an offset value (K) is added.

## Revendications

1. Dispositif de mesure de position à test de fonctionnement intégré, constitué d'une unité de détection de position (10; 210), une unité de traitement (80; 280) et un générateur de mot de commande (50; 250), dans lequel
• un mot de données de position contenant une valeur de position actuelle et un mot de données de commande peuvent être générés dans l'unité de détection de position (10; 210) et délivrés à l'unité de traitement (10; 210),
• l'unité de détection de position (10; 210) est reliée à l'unité de traitement (80; 280), qui comporte des moyens (81, 82; 281, 282, 283, 284) destinés à générer une valeur de position à partir du mot de données de position et une valeur de commande à partir du mot de données de commande, dans lequel la valeur de commande et la valeur de position présentent une relation mathématique définie l'une par rapport à l'autre,
• le générateur de mot de commande (50; 250) comprend un moyen (51, 52; 251) permettant d'établir si le mot de données de position ou le mot de données de commande est délivré par l'unité de détection de position (10; 210).

2. Dispositif de mesure de position selon la revendication 1, dans lequel la valeur de position peut être stockée dans une mémoire de résultats (30) et la valeur de commande peut être stockée dans une mémoire de valeurs de commande (40).

3. Dispositif de mesure de position selon la revendication 2, dans lequel le contenu de la mémoire de résultats (30) et le contenu de la mémoire de valeurs de commande (40) peuvent être transmis au moyen d'une unité d'interface (70) par le biais d'une ligne de transmission de données (71) à une électronique aval (90).

4. Dispositif de mesure de position selon l'une des revendications précédentes, dans lequel l'unité de détection de position (10) comporte des moyens (12, 15) destinés à remplacer le mot de données de position par le mot de données de commande.

5. Dispositif de mesure de position selon la revendication 4, dans lequel les moyens (12, 15) destinés à remplacer le mot de données de position par le mot de données de commande sont constitués d'un convertisseur tension-courant (15) et d'au moins un point nodal de courant (12).

6. Dispositif de mesure de position selon l'une des revendications 1 à 3, dans lequel il est prévu un moyen (251) permettant d'imposer une valeur de position invalide dans l'unité de détection de position (210).

7. Dispositif de mesure de position selon la revendication 6, dans lequel le moyen (251) permettant d'imposer une valeur de position invalide dans l'unité de détection de position (210) est constitué par une ligne de commutation (251) qui va du générateur de mot de commande (250) à un capteur de valeur de mesure (211) et le capteur de valeur de mesure (211) peut être désactivé par le biais de la ligne de commutation (251).

8. Procédé de mesure de position dans un dispositif de mesure de position à test de fonctionnement intégré, qui est constitué d'une unité de détection de position (10; 210), d'une unité de traitement (80; 280) et d'un générateur de mot de commande (50; 250), comprenant les étapes suivantes:
• générer un mot de données de position dans l'unité de détection de position (10; 210) et délivrer le mot de données de position à l'unité de traitement (80; 280),
• traiter le mot de données de position pour obtenir une valeur de position dans l'unité de traitement (80; 280),
• générer un mot de données de commande dans l'unité de détection de position (10; 210) sur la base de la spécification du générateur de mot de commande (50; 250) et délivrer le mot de données de commande à l'unité de traitement (80; 280),
• traiter le mot de données de commande dans l'unité de traitement (80; 280) pour obtenir une valeur de commande qui présente une relation mathématique définie par rapport à la valeur de position,
dans lequel il est établi au moyen du générateur de mot de commande (50; 250) si le mot de données de position ou le mot de données de commande est délivré par l'unité de détection de position (10; 210).

9. Procédé selon la revendication 8, dans lequel la valeur de position est stockée dans une mémoire de résultats (30) et la valeur de commande est stockée dans une mémoire de valeurs de commande (40).

10. Procédé selon la revendication 9, dans lequel la valeur de position stockée dans la mémoire de résultats (30) et la valeur de commande stockée dans la mémoire de valeurs de commande (40) sont toutes deux transmises par une unité d'interface (70) par le biais d'une ligne de transmission de signaux (71) à une électronique aval (90).

11. Procédé selon l'une des revendications 8 à 10, dans lequel le mot de données de commande remplace le mot de données de position dans l'unité de détection de position (10) .

12. Procédé selon l'une des revendications 8 à 10, dans lequel le mot de données de commande est généré en faisant en sorte qu'une valeur de position invalide soit imposée par le générateur de mot de commande (250) dans l'unité de détection de position (210).

13. Procédé selon la revendication 12, dans lequel la valeur de position invalide est imposée en faisant en sorte qu'un capteur de valeur de mesure (211) soit désactivé dans l'unité de détection de position (210) par le biais d'une ligne de commutation (251).

14. Procédé selon la revendication 12 ou 13, dans lequel la valeur de commande générée par l'unité de traitement (280) lorsque le mot de données de commande ne contient pas de valeur de position valide est constituée par la valeur de position déterminée au préalable à laquelle est ajoutée une valeur de décalage (K).
